# EUROPEAN PATENT SPECIFICATION

(11) **EP 2 003 328 B1**
(45) Date of publication and mention of the grant of the patent: **10.08.2011**
(21) Application number: 07011599.3
(22) Date of filing: 13.06.2007
(51) Int. Cl.: F02M 51/00

(54) **Electrical connector for an injector**
Elektrischer Verbinder für einen Injektor
Connecteur électrique pour injecteur

(43) Date of publication of application: 17.12.2008
(73) Proprietor: Continental Automotive GmbH, 30165 Hannover (DE)
(72) Inventor: Biasci, Enio, 56010 Campo (Pisa) (IT); Zimmitti, Federico, 56121 Pisa (IT)

(56) References cited:
- DE-A1- 3 220 090
- DE-A1- 4 321 331
- DE-A1-102005 042 759
- JP-A- 4 318 273

## Description

The invention relates to an electrical connector for an injector.

In order to meet the requirements of strict emission legalisation and in order to save fuel consumption, injectors, in particular fuel injectors for internal combustion engines are arranged in internal combustion engines in order to dose the fluid into an intake manifold of the internal combustion engine or directly into the combustion chamber of a cylinder of the internal combustion engine.

Injectors for an internal combustion engine comprise actuator units. In order to inject fuel, the actuator unit is energized so that a fluid flow through the fluid outlet portion of the injection valve is enabled.

In order to enhance the combustion process in view of the creation of unwanted emissions, the respective injector may be suited to dose fluids under very high pressures. The pressures may be in case of a gasoline engine, for example the range of up to 200 bar or in the case of diesel engines in the range of up to 2,000 bar. The injection of fluids under such high pressures has to be carried out very precisely.

During the injection process very fast changes of the pressure may occur. The fast changes of the pressure may cause pressure waves in the fluid which leads to pressure waves in different parts of the injector, in particular in the actuator unit.

DE 32 20 090 A1 discloses a device which serves for the electrical contacting of an electromagnetically actuated fuel injection valve for fuel injection systems of internal combustion engines. A fuel injection valve is arranged in an intake pipe, parallel to the direction of flow of the intake air. Protruding from its valve housing are at least two contact pin ends and it is surrounded by a plastic casing which has contact openings leading to the contact pin ends. A cap with a connection piece extending almost as far as the wall of the intake pipe is placed over the plastic casing. The connection piece has a lead-in opening through which there project contact lugs which, on the one hand, are secured in insulated fashion in a connector and, on the other hand, partially surround the contact pin ends resiliently with fork-shaped free ends.

JP 4318273 A discloses a fuel injection valve. A terminal 41 is constituted of a single thin plate metal to form a side of a coil bobbin 34 of the terminal 41 into a tubular base end part 41a and a side of a connector 40 of the terminal 41 into a flat plate-shaped final end part 41b by press molding a tubular thin plate metal.

DE 10 2005 042 759 A1 discloses a piezoelectric actuator. The discharge circuit of the electric charge generated according to the pyroelectric effect was formed at the piezo stack. The discharge circuit was arranged between the terminal metal fittings and the metal body members. The electrode lead rods were arranged at the piezo stack and extend to the connector. The connector was integrated the terminal metal fitting in the conductive resin section.

DE 43 21 331 discloses a built-on control device. The built-on control device has a multi-component housing which is open on one side and is fitted onto the housing block of a hydraulic unit. Arranged in the housing of the built-on control device is a printed circuit board for an electronic circuit with a plurality of electronic components. The printed circuit board comprises a plurality of rigid regions, one rigid region being formed by the lid of the housing. A loop-like flexible region, which comprises only the conductor foil, is located between the two rigid regions. In addition, the conductor foil projects beyond the rigid region f the printed circuit board and in this region it is placed in contact with the connection pins of the loads of the hydraulic unit.

The object of the invention is to create an electrical connector for an injector that is simply to be manufactured and which facilitates a reliable and precise function of the injection valve.

These objects are achieved by the features of the independent claim. Advantageous embodiments of the invention are given in the sub-claims.

According to a first aspect the invention is distinguished by an electrical connector for an injector comprising a connector body, a pin being mechanically coupled to the connector body and being electrically coupable to a power supply, an electric conductor being electrically coupled to the pin, the electric conductor comprising a first conducting element having a.first rigidity and being electrically coupable to an actuator unit of the injector, and a second conducting element being a wire element being elastically deformable and having a second rigidity, the first rigidity being greater than the second rigidity, the second conducting element being electrically coupled to the first conducting element, and a non-conductive coupling element mechanically coupled to the first conducting element and being coupled to the connector body and having a rigidity being greater than the second rigidity of the second conducting element. The non-conductive coupling element comprises an attenuation zone which has a recess being formed in a manner that a cross sectional area of the attenuation zone of the non-conductive coupling element is smaller than a cross sectional area of further sections of the non-conductive coupling element

This has the advantage that due to that the rigidity of the non-conductive coupling element is greater than the rigidity of the second conducting element the non-conductive coupling element can serve as a secure rigid coupling element between the connector body and the first conducting element. Furthermore, a destruction of the non-conductive coupling element due to high mechanical forces exerted on the actuator unit is possible, but a secure electrical and mechanical coupling between the actuator unit and the electrical connector is remaining via the second conducting element. Consequently, a damage of the injector can be avoided even in the case of high mechanical forces exerted on the actuator unit. Additionally, a simple construction of the attenuation zone is possible.

In an advantageous embodiment a further pin is mechanically coupled to the connector body and is electrically coupable to a power supply, a further electric conductor is electrically coupled to the further pin, the further electric conductor comprising a third conducting element having a third rigidity and being electrically coupable to the actuator unit of the injector, and a fourth conducting element being elastically deformable and having a fourth rigidity, the third rigidity being greater than the fourth rigidity, the fourth conducting element is electrically coupled to the third conducting element, the non-conductive coupling element is mechanically coupled to the third conducting element and has a rigidity being greater than the fourth rigidity of the fourth conducting element. This makes it possible to apply the non-conductive coupling element on two-wire-connectors.

In a further advantageous embodiment the non-conductive coupling element is T-shaped. This makes a simple construction of the non-conductive coupling element for two-wire-connectors possible.

Exemplary embodiments of the invention are explained in the following with the help of schematic drawings. These are as follows:
- Figure 1: a part of an injector with an electrical connector in a longitudinal section view, and

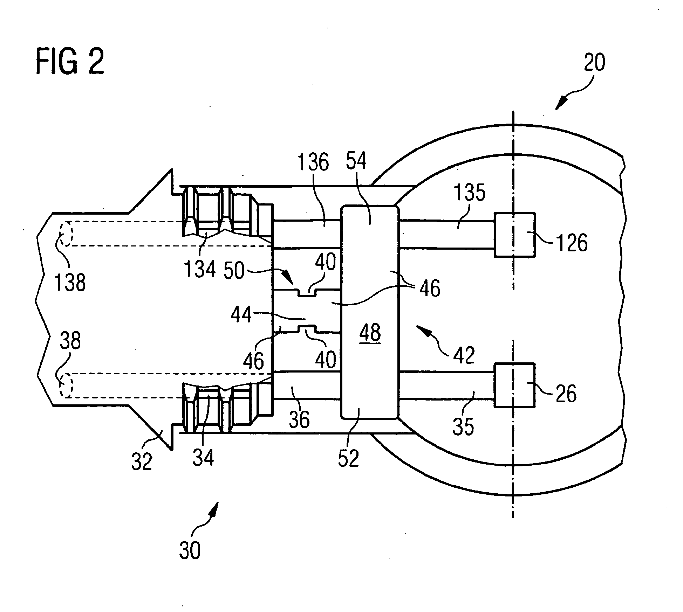

- Figure 2: the electrical connector in a top view.

Elements of the same design and function that appear in different illustrations are identified by the same reference characters.

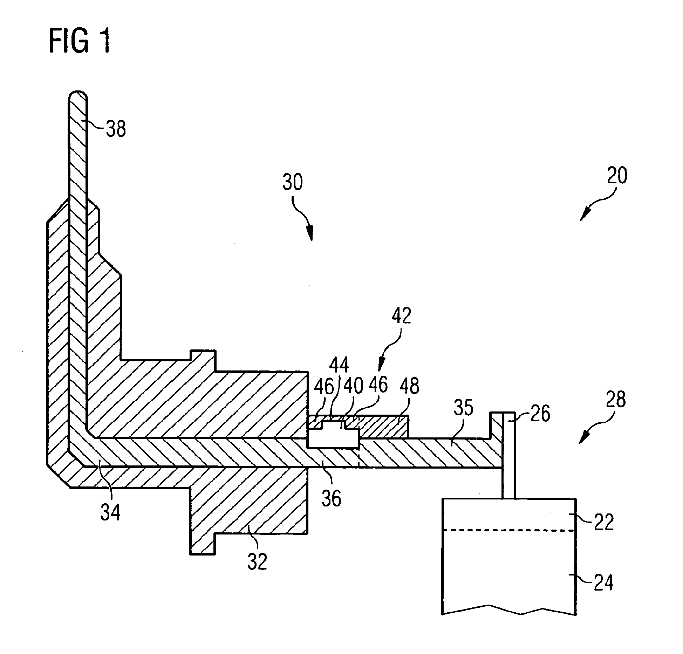

Figure 1 shows a part of an injector 20 with an actuator unit 28 and an electrical connector 30.

The actuator unit 28 comprises a housing 22 in which a piezo element 24 is arranged. The actuator unit 28 may, however, also comprise another type of actuator, which is known to the person skilled in the art for that purpose. Such an actuator may be, for example, a solenoid. The actuator unit 28 further comprises pins 26, 126 for the supply of electrical energy to the actuator unit 28. The piezo element 24 of the actuator unit 28 may change its axial length if it is supplied with electrical energy. By changing its length the actuator unit 28 may exert a force on a valve needle of the injector 20. Due to the exerted force the valve needle is able to move in axial direction to prevent or enable a fluid flow through the injector 20.

The electrical connector 30 has a connector body 32 in which electric conductors 34, 134 and pins 38, 138 are arranged. Each of the electric conductors 34, 134 is electrically coupled with one of the pins 38, 138 of the electrical connector 30 and with one of the pins 26, 126 of the actuator unit 28. A power supply can be coupled to the pins 38, 138 of the electrical connector 30 to supply the actuator unit 28 with electrical energy.

The electric conductor 34 comprises a first conducting element 35 and a second conducting element 36. The first conducting element 35 has a first rigidity. The second conducting element 36 is elastically deformable and has a second rigidity which is smaller than the first rigidity of the first conducting element 35. The first conducting element 35 and the second conducting element 36 are electrically coupled with each other in a manner that a current flow through the first conducting element 35 and the second conducting element 36 is enabled.

Accordingly, the electric conductor 134 comprises a third conducting element 135 and a fourth conducting element 136. The third conducting element 135 has a third rigidity. The fourth conducting element 136 is elastically deformable and has a fourth rigidity which is smaller than the third rigidity of the third conducting element 135. The third conducting element 135 and the fourth conducting element 136 are electrically coupled with each other in a manner that a current flow through the third conducting element 135 and the fourth conducting element 136 is enabled.

The electrical connector 30 further comprises a T-shaped non-conductive coupling element 42. In alternative embodiments the non-conductive coupling element 42 can have different forms, for example the non-conductive coupling element 42 can be Y-shaped. The non-conductive coupling element 42 is preferably made of plastic. The T-shaped non-conductive coupling element 42 has a crossbeam 48 and a base 50. A first end 52 of the crossbeam 48 is mechanically coupled to the first conducting element 35, a second end 54 of the crossbeam 48 is mechanically coupled to the third conducting element 135 and the base 50 is mechanically coupled to the connector body 32.

The non-conductive coupling element 42 thereby bridges the second conducting element 36 and the fourth conducting element 136 mechanically.

The non-conductive coupling element 42 has an attenuation zone 44 and further sections 46. The attenuation zone 44 is an area structurally weakened relative to the further sections 46. The attenuation zone 44 of the non-conductive coupling element 42 is arranged between two of the further sections 46 of the non-conductive coupling element 42 and has a recess 40. Due to the recess 40 the cross sectional area of the attenuation zone 44 of the non-conductive coupling element 42 is smaller than the cross sectional area of the further sections 46 of the non-conductive coupling element 42.

Preferably, the second conducting element 36 is a wire. Wire elements enable a good elastic deformability of the second conducting element 36. Consequently, a high elasticity between the connector body 32 and the actuator unit 28 is available. Preferably, the second conducting element 36 comprises a plurality of wire elements which enable a very good elastic deformability of the second conducting element 36.

In the following a method for coupling the electrical connector 30 to the actuator unit 28 of the injector 20 will be described:

The electrical connector 30 and the actuator unit 28 of the injector 20 are provided. The electrical connector 30 is aligned relative to the actuator unit 28 of the injector 20. As the first rigidity of the first conducting element 35, the third rigidity of the third conducting element 135 and the rigidity of the non-conductive coupling element 42 is high it is possible to obtain a well-defined position of the electrical connector 30 relative to the actuator unit 28 of the injector. Furthermore, the first conducting element 35 of the electric conductor 34 of the electrical connector 30 is coupled to the pin 26 of the actuator unit 28 and the third conducting element 135 of the electric conductor 134 of the electrical connector 30 is coupled to the pin 126 of the actuator unit 28. This coupling is preferably carried out by welding and provides a robust electrical coupling between the electrical connector 30 and the actuator unit 28 of the injector. Finally, the attenuation zone 44 of the base 50 of the non-conductive coupling element 42 can be removed. This enables an elastic coupling between the first conducting element 35 and the connector body 32 through the second conducting element 36 as well as an elastic coupling between the third conducting element 135 and the connector body 32 through the fourth conducting element 136.

In the following the function of the electrical connector 30 of the injector 20 will be described:

If the actuator unit 28 of the injector 20 is energized through the electrical connector 30 the valve needle is enabled to move as described above and to exert a reaction force on the actuator unit 28. Due to this a movement of the actuator unit 28 relative to the electrical connector 30 can occur in a manner that forces are exerted on the first conducting element 35 and the second conducting element 36.

If the attenuation zone 44 of the non-conductive coupling element 42 is intact a rigid coupling of the first conducting element 35 and the third conducting element 135 with the connector body 32 is enabled.

If the forces due to the movement of the actuator unit 28 relative to the electrical connector 30 are high enough to destroy the attenuation zone 44 of the non-conductive coupling element 42 which has a high rigidity or the attenuation zone 44 of the non-conductive coupling element 42 is removed the second conducting element 36 enables a mechanical coupling between the connector body 32 and the first conducting element 35 and a current flow through the second conducting element 36 as well as the fourth conducting element 136 enables a mechanical coupling between the connector body 32 and the third conducting element 135 and a current flow through the fourth conducting element 136.

Consequently, the actuator unit 28 is supplied with electrical energy in a secure manner as the second rigidity of the second conducting element 36 is smaller than the first rigidity of the first conducting element 35 and the second conducting element 36 is elastically deformable as well as the fourth rigidity of the fourth conducting element 136 is smaller than the third rigidity of the third conducting element 135 and the fourth conducting element 136 is elastically deformable. Therefore, the transmission of mechanical stress to the pins 26, 126 of the actuator unit 28 can be prevented.

This allows to obtain a long life time of the actuator unit 28 by a robust coupling between the electric conductors 34, 134 of the electrical connector 30 and the pins 26, 126 of the actuator unit.

## Claims

1. Electrical connector (30) for an injector (20) comprising
- a connector body (32),
- a pin (38) being mechanically coupled to the connector body (32) and being electrically coupable to a power supply,
- an electric conductor (34) being electrically coupled to the pin (38), the electric conductor (34) comprising a first conducting element (35) having a first rigidity and being electrically coupable to an actuator unit (28) of the injector (20), and a second conducting element (36) being a wire element being elastically deformable and having a second rigidity, the first rigidity being greater than the second rigidity, the second conducting element (36) being electrically coupled to the first conducting element (35), and
- a non-conductive coupling element (42) mechanically coupled to the first conducting element (35) and being coupled to the connector body (32) and having a rigidity being greater than the second rigidity of the second conducting element (36), the non-conductive coupling element (42) comprising an attenuation zone (44) having a recess (40) being formed in a manner that a cross sectional area of the attenuation zone (44) of the non-conductive coupling element (42) is smaller than a cross sectional area of further sections (46) of the non-conductive coupling element (42).

2. Electrical connector (30) according to claim 1, with
- a further pin (138) being mechanically coupled to the connector body (32) and being electrically coupable to a power supply, a further electric conductor (134) being electrically coupled to the further pin (138), the further electric conductor (134) comprising a third conducting element (135) having a third rigidity and being electrically coupable to the actuator unit (28) of the injector (20), and a fourth conducting element (136) being elastically deformable and having a fourth rigidity, the third rigidity being greater than the fourth rigidity, the fourth conducting element (136) being electrically coupled to the third conducting element (135),
- the non-conductive coupling element (42) being mechanically coupled to the third conducting element (135) and having a rigidity being greater than the fourth rigidity of the fourth conducting element (136).

3. Electrical connector (30) according to claim 2, with the non-conductive coupling element (42) being T-shaped.

## Patentansprüche

1. Elektrischer Verbinder (30) für einen Injektor (20) umfassend
• einen Verbinderkörper (32),
• einen mechanisch mit dem Verbinderkörper (32) verbundenen Stift (38), der auch elektrisch mit einer Stromversorgung verbindbar ist,
• einen elektrisch mit dem Stift (38) verbundenen elektrischen Leiter (34), wobei der elektrische Leiter (34) ein erstes leitendes Element (35) mit einer ersten Steifigkeit, das mit einer Stelleinheit (28) des Injektors (20) elektrisch verbindbar ist, und ein zweites leitendes Element (36) umfasst, welches ein elastisch verformbares Drahtelement mit einer zweiten Steifigkeit ist, wobei die erste Steifigkeit größer als die zweite Steifigkeit ist und das zweite leitende Element (36) mit dem ersten leitenden Element (35) elektrisch verbundenen ist, und
• ein nicht leitendes Verbindungselement (42), mechanisch verbunden mit dem ersten leitenden Element (35) und mit dem Verbinderkörper (32) verbunden und mit einer Steifigkeit, die größer als die zweite Steifigkeit des zweiten leitenden Elements (36) ist, wobei das nicht leitende Verbindungselement (42) eine Dämpfungszone (44) mit einer Ausnehmung umfasst, die so ausgebildet ist, dass eine Querschnittsfläche der Dämpfungszone (44) des nicht leitenden Verbindungselements (42) kleiner ist als eine Querschnittsfläche von weiteren Abschnitten (46) des nicht leitenden Verbindungselements (42).

2. Elektrischer Verbinder (30) gemäß Anspruch 1, mit
• einem mit dem Verbinderkörper (32) mechanisch verbundenen weiteren Stift (138), der auch elektrisch mit einer Stromversorgung verbindbar ist, wobei ein weiterer elektrischer Leiter (134) elektrisch mit dem weiteren Stift (138) verbunden ist, wobei der weitere elektrische Leiter (134) ein drittes leitendes Element (135) mit einer dritten Steifigkeit, das mit der Stelleinheit (28) des Injektors (20) elektrisch verbindbar ist umfasst, sowie ein viertes leitendes Element (136), das elastisch verformbar ist und eine vierte Steifigkeit aufweist, wobei die dritte Steifigkeit größer als die vierte Steifigkeit ist und das vierte leitende Element (136) mit dem dritten leitenden Element (135) elektrisch verbundenen ist,
• wobei das nicht leitende Verbindungselement (42) mit dem dritten leitenden Element (135) mechanisch verbunden ist und eine Steifigkeit größer als die vierte Steifigkeit des vierten leitenden Elements (136) aufweist.

3. Elektrischer Verbinder (30) gemäß Anspruch 2, wobei das nicht leitende Verbindungselement (42) T-förmig ist.

## Revendications

1. Connecteur électrique (30) pour un injecteur (20) comprenant :
- un corps de connecteur (32),
- une broche (38) qui est couplée mécaniquement au corps de connecteur (32) et peut être électriquement couplée à une alimentation de puissance,
- un conducteur électrique (34) qui est électriquement couplé à la broche (38), le conducteur électrique (34) comprenant un premier élément conducteur (35) ayant une première rigidité et qui peut être électriquement couplé à une unité d'actionneur (28) de l'injecteur (20) et un deuxième élément conducteur (36) qui est un élément formant fil qui peut être déformé élastiquement et ayant une deuxième rigidité, la première rigidité étant supérieure à la deuxième rigidité, le deuxième élément conducteur (36) étant couplé électriquement au premier élément conducteur (35), et
- un élément de couplage non conducteur (42) mécaniquement couplé au premier élément conducteur (35) et étant couplé au corps de connecteur (32) et ayant une rigidité qui est supérieure à la deuxième rigidité du deuxième élément conducteur (36), l'élément de couplage non conducteur (42) comprenant une zone d'atténuation (44) ayant un évidement (40) qui est formé de sorte qu'une surface transversale de la zone d'atténuation (44) de l'élément de couplage non conducteur (42) est inférieure à une surface transversale des autres sections (46) de l'élément de couplage non conducteur (42).

2. Connecteur électrique (30) selon la revendication 1, avec :
- une broche supplémentaire (138) qui est couplée mécaniquement au corps de connecteur (32) et pouvant être couplée électriquement à une alimentation de courant, un conducteur électrique supplémentaire (134) étant couplé électriquement à la broche supplémentaire (138), le conducteur électrique supplémentaire (134) ayant un troisième élément conducteur (135) ayant une troisième rigidité et pouvant être couplé électriquement à l'unité d'actionneur (28) de l'injecteur (20), et un quatrième élément conducteur (136) qui est élastiquement déformable et ayant une quatrième rigidité, la troisième rigidité étant supérieure à la quatrième rigidité, le quatrième élément conducteur (136) pouvant être couplé électriquement au troisième élément conducteur (135),
- l'élément de couplage non conducteur (42) étant mécaniquement couplé au troisième élément conducteur (135) et ayant une rigidité qui est supérieure à la quatrième rigidité du quatrième élément conducteur (136).

3. Connecteur électrique (30) selon la revendication 2, avec l'élément de couplage non conducteur (42) qui est en forme de T.
